# EUROPEAN PATENT APPLICATION

(11) **EP 4 436 346 A1**
(43) Date of publication of application: **25.09.2024**
(21) Application number: 24164539.9
(22) Date of filing: 19.03.2024
(51) Int. Cl.: H10K 59/80

(54) **DISPLAY PANEL AND ELECTRONIC APPARATUS INCLUDING THE SAME**

(30) Priority: 20.03.2023 KR 20230036162
(71) Applicant: Samsung Display Co., Ltd., Yongin-si, Gyeonggi-do 17113 (KR)
(72) Inventor: Lee, Jongchan, 17113 Yongin-si, Gyeonggi-do (KR); Lee, Jinsuk, 17113 Yongin-si, Gyeonggi-do (KR); Yang, Yongho, 17113 Yongin-si, Gyeonggi-do (KR); Tae, Seunggyu, 17113 Yongin-si, Gyeonggi-do (KR)
(74) Representative: Gulde & Partner

(57) **Abstract**

A display panel (10) includes a light-emitting diode (LED) arranged in a display area (DA) around an opening (100OP) of a substrate (100), a thin-film encapsulation layer (300) on the light-emitting diode (LED), a first separator (SP, SP1) and a second separator (SP) arranged in a first non-display area (NDA1) between the opening (100OP) of the substrate (100) and the display area (DA), wherein the first separator (SP, SP1) includes a first inorganic insulating layer (1110) and a second inorganic insulating layer (1120) on an upper surface of the first inorganic insulating layer (1110) and arranged in a first direction (z) perpendicular to the substrate (100), wherein the first separator (SP, SP1) includes a first cantilever portion (SPC) and a second cantilever portion (SPC) opposite to the first cantilever portion (SPC), and wherein the first cantilever portion (SPC) has a first gap (g1, g1', g1‴) in the first direction (z) from a lower layer (203) under the first separator (SP, SP1), and has a first length (ℓ) in a second direction crossing the first direction (z).

## Description

### BACKGROUND

### 1. Field

Aspects of one or more embodiments relate to a display panel and an electronic apparatus including the same.

### 2. Description of Related Art

Recently, the various uses of display panels have become more diversified. In addition, as display panels have become relatively thinner and lighter, their range of uses has been gradually expanded.

As the area occupied by the display area in display panels expands, various functions that are combined or associated with the display panels have been added. As alternatives for adding various functions while extending a display area, research has been carried out on using a portion of the display area for functions other than displaying images.

The above information disclosed in this Background section is only for enhancement of understanding of the background and therefore the information discussed in this Background section does not necessarily constitute prior art.

### SUMMARY

Aspects of one or more embodiments include a display panel including at least one opening arranged inside a display area, and an electronic apparatus including the display panel.

Additional aspects will be set forth in part in the description which follows and, in part, will be apparent from the description, or may be learned by practice of the presented embodiments of the disclosure.

According to one or more embodiments, a display panel includes a substrate including an opening passing through an upper surface thereof and a lower surface thereof, a light-emitting diode arranged in a display area around the opening and including a first electrode, a second electrode, and an intermediate layer between the first electrode and the second electrode, a thin-film encapsulation layer on the light-emitting diode and including an organic encapsulation layer and at least one inorganic encapsulation layer, a first separator arranged in a first non-display area between the opening of the substrate and the display area, and a second separator apart from the first separator in the first non-display area, wherein the first separator includes a first inorganic insulating layer, and a second inorganic insulating layer on an upper surface of the first inorganic insulating layer in a first direction perpendicular to the substrate, and wherein the first separator includes a first cantilever portion and a second cantilever portion opposite to the first cantilever portion, wherein the first cantilever portion has a first gap in the first direction from a lower layer under the first separator, and has a first length in a second direction crossing the first direction.

According to some embodiments, the first separator may include an intermediate portion between the first cantilever portion and the second cantilever portion, and a first height from a lower surface of the substrate to an upper surface of the intermediate portion may be less than a second height from the lower surface of the substrate to an upper surface of at least one of the first cantilever portion or the second cantilever portion.

According to some embodiments, the display panel may further include a metal residue between the first cantilever portion and the lower layer.

According to some embodiments, the first cantilever portion may have a structure including a portion of the first inorganic insulating layer and a portion of the second inorganic insulating layer overlapping each other.

According to some embodiments, the portion of the second inorganic insulating layer may be in direct contact with the portion of the first inorganic insulating layer.

According to some embodiments, the portion of the second inorganic insulating layer may have a second gap in the first direction from the portion of the first inorganic insulating layer.

According to some embodiments, there may be a metal residue under the portion of the second inorganic insulating layer.

According to some embodiments, the first cantilever portion may include a portion of the second inorganic insulating layer, wherein the portion of the second inorganic insulating layer may have the first gap in the first direction from the lower layer.

According to some embodiments, a width of the first inorganic insulating layer may be less than a width of the second inorganic insulating layer, and the second inorganic insulating layer may be in direct contact with an entire upper surface of the first inorganic insulating layer.

According to some embodiments, the second cantilever portion may include a portion of the first inorganic insulating layer, wherein the second cantilever portion may have a second gap in the first direction from the lower layer, and wherein the second gap may be less than the first gap.

According to some embodiments, the lower layer may include a recess located in a separation region between the first separator and the second separator.

According to some embodiments, the at least one inorganic encapsulation layer of the thin-film encapsulation layer may be in direct contact with each of a portion of the first cantilever portion and a portion of the second cantilever portion of the first separator.

According to one or more embodiments, an electronic apparatus includes a display panel including a transmissive area, a display area, and a first non-display area, wherein the display area surrounds the transmissive area, and the first non-display area is between the transmissive area and the display area, and a component arranged to overlap the transmissive area of the display panel, wherein the display panel includes a substrate including an opening passing through an upper surface thereof and a lower surface thereof, wherein the opening corresponds to the transmissive area, a light-emitting diode corresponding to the display area and including a first electrode, a second electrode, and an intermediate layer between the first electrode and the second electrode, a thin-film encapsulation layer on the light-emitting diode and including an organic encapsulation layer and at least one inorganic encapsulation layer, a first separator on the substrate to correspond to the first non-display area, and a second separator apart from the first separator in the first non-display area, wherein each of the first separator and the second separator includes a first inorganic insulating layer, and a second inorganic insulating layer on an upper surface of the first inorganic insulating layer in a first direction perpendicular to the substrate, wherein the first inorganic insulating layer of the first separator is separated from the first inorganic insulating layer of the second separator, wherein the first separator includes a first cantilever portion and a second cantilever portion opposite to the first cantilever portion, and wherein the first cantilever portion has a first gap in the first direction from a lower layer under the first separator.

According to some embodiments, the first separator may include an intermediate portion of the first separator present between the first cantilever portion and the second cantilever portion, and a first height from a lower surface of the substrate to an upper surface of the intermediate portion may be less than a second height from the lower surface of the substrate to an upper surface of at least one of the first cantilever portion or the second cantilever portion.

According to some embodiments, the display panel may further include a metal residue between the first cantilever portion and the lower layer.

According to some embodiments, the first cantilever portion of the first separator may have a structure in which a portion of the first inorganic insulating layer and a portion of the second inorganic insulating layer are in direct contact with each other.

According to some embodiments, the first cantilever portion of the first separator may include a portion of the first inorganic insulating layer having the first gap in the first direction from the lower layer, and a portion of the second inorganic insulating layer having a second gap in the first direction from the portion of the first inorganic insulating layer.

According to some embodiments, the electronic apparatus may further include a metal residue present under the portion of the second inorganic insulating layer and under the portion of the first inorganic insulating layer.

According to some embodiments, a width of the first inorganic insulating layer may be less than a width of the second inorganic insulating layer, and the second inorganic insulating layer may be in direct contact with an entire upper surface of the first inorganic insulating layer, and wherein the first cantilever portion of the first separator may include a portion of the second inorganic insulating layer, wherein the portion of the second inorganic insulating layer may have the first gap in the first direction from the lower layer.

According to some embodiments, the first cantilever portion of the first separator may have the first gap in the first direction from the lower layer, and the second cantilever portion of the first separator may have a second gap in the first direction from the lower layer, wherein the first gap may be greater than the second gap.

According to some embodiments, the lower layer may include a recess located in a separation region between the first separator and the second separator.

According to some embodiments, the at least one inorganic encapsulation layer of the thin-film encapsulation layer may be in direct contact with each of a portion of the first cantilever portion and a portion of the second cantilever portion of the first separator.

According to some embodiments, the display panel may include an opening passing through the display panel and arranged in the transmissive area corresponding to the opening of the substrate.

According to some embodiments, the component may include a sensor or a camera.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects, features, and characteristics of certain embodiments of the disclosure will be more apparent from the following description taken in conjunction with the accompanying drawings, in which:
FIG. 1 is a schematic perspective view of an electronic apparatus according to some embodiments;
FIG. 2 is a schematic cross-sectional view of a display panel, taken along a line II-II' of FIG. 1, according to some embodiments;
FIG. 3 is a plan view of a portion of a display panel according to some embodiments;
FIG. 4 is a cross-sectional view of a portion of a display panel according to some embodiments;
FIG. 5 is a schematic cross-sectional view of separators of the display panel shown in FIG. 4 according to some embodiments;
FIGS. 6A to 6C are schematic cross-sectional views showing a process of forming a separator of a display panel, according to some embodiments;
FIG. 7 is a schematic cross-sectional view of separators arranged in a first non-display area of a display panel, according to some embodiments;
FIG. 8 is a schematic cross-sectional view of separators arranged in a first non-display area of a display panel, according to some embodiments;
FIG. 9 is a schematic cross-sectional view of separators arranged in a first non-display area of a display panel, according to some embodiments;
FIG. 10 is a schematic cross-sectional view of separators arranged in a first non-display area of a display panel, according to some embodiments; and
FIG. 11 is a schematic cross-sectional view of separators of the display panel and a neighboring portion thereof, according to some embodiments.

### DETAILED DESCRIPTION

Reference will now be made in more detail to aspects of some embodiments, which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or any combination of a, b, and/or c.

As the disclosure allows for various changes and numerous embodiments, certain embodiments will be illustrated in the drawings and described in the written description. Effects and features of the disclosure, and methods for achieving them will be clarified with reference to embodiments described below in detail with reference to the drawings. However, the disclosure is not limited to the following embodiments and may be embodied in various forms.

Hereinafter, aspects of some embodiments will be described with reference to the accompanying drawings, wherein like reference numerals refer to like elements throughout and a repeated description thereof is omitted.

While such terms as "first" and "second" may be used to describe various elements, such elements must not be limited to the above terms. The above terms are used to distinguish one element from another.

The singular forms "a," "an," and "the" as used herein are intended to include the plural forms as well unless the context clearly indicates otherwise.

It will be understood that the terms "comprise," "comprising," "include" and/or "including" as used herein specify the presence of stated features or elements but do not preclude the addition of one or more other features or elements.

It will be further understood that, when a layer, region, or element is referred to as being "on" another layer, region, or element, it can be directly or indirectly on the other layer, region, or element. That is, for example, intervening layers, regions, or elements may be present.

Sizes of elements in the drawings may be exaggerated or reduced for convenience of explanation. As an example, the size and thickness of each element shown in the drawings are arbitrarily represented for convenience of description, and thus, the disclosure is not necessarily limited thereto.

In the case where a certain embodiment may be implemented differently, a specific process order may be performed in the order different from the described order. As an example, two processes successively described may be simultaneously or concurrently performed substantially and performed in the opposite order.

It will be understood that when a layer, region, or component is referred to as being "connected" to another layer, region, or component, it may be "directly connected" to the other layer, region, or component or may be "indirectly connected" to the other layer, region, or component with another layer, region, or component interposed therebetween. For example, it will be understood that when a layer, region, or element is referred to as being "electrically connected" to another layer, region, or element, it may be "directly electrically connected" to the other layer, region, or element or may be "indirectly electrically connected" to the other layer, region, or element with another layer, region, or element located therebetween.

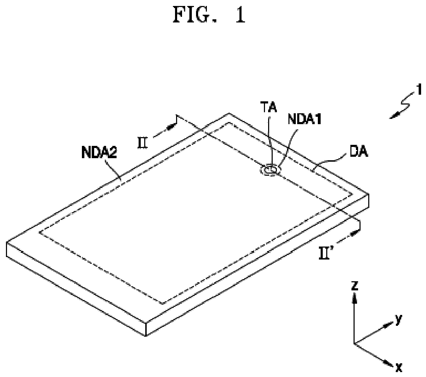

FIG. 1 is a schematic perspective view of an electronic apparatus 1 according to some embodiments.

Referring to FIG. 1, the electronic apparatus 1 may include an apparatus for displaying moving images (e.g., video images) or still images (e.g., static images) and may be used as a display screen of various products including televisions, notebook computers, monitors, advertisement boards, Internet of things (IoT) as well as portable electronic apparatuses including mobile phones, smartphones, tablet personal computers (PCs), mobile communication terminals, electronic organizers, electronic books, portable multimedia players (PMPs), navigations, and ultra-mobile personal computers (UMPCs). In addition, the electronic apparatus 1 may be used in wearable devices including smartwatches, watchphones, glasses-type displays, and head-mounted displays (HMDs). In addition, according to some embodiments, the electronic apparatus 1 may be used as a display in instrument panels for automobiles, center fascias for automobiles, or center information displays (CIDs) arranged on a dashboard, room mirror displays that replace side mirrors of automobiles, and displays of an entertainment system arranged on the backside of front seats for backseat passengers in automobiles. For convenience of description and illustration, FIG. 1 shows the case where the electronic apparatus 1 according to some embodiments is used as a smartphone, but embodiments according to the present disclosure are not limited thereto.

The electronic apparatus 1 may have a rectangular shape in a plan view. As an example, as shown in FIG. 1, the electronic apparatus 1 may have a quadrangular shape having short sides of the x direction and long sides of the y direction in a plan view. A corner where the short side of the x direction meets the long side of the y direction may be round to have a preset curvature or formed to have a right angle. A planar shape of the electronic apparatus 1 is not limited to a rectangle, but may be other polygons, ellipses, or irregular shapes.

The electronic apparatus 1 may include a transmissive area TA (or a first region) and a display area DA (or a second region) at least partially surrounding the transmissive area TA. The electronic apparatus 1 may include a first non-display area NDA1 (or a third region) and a second non-display area NDA2 (or a fourth region), wherein the first non-display area NDA1 is located between the transmissive area TA and the display area DA, and the second non-display area NDA2 is located outside the display area DA, for example, surrounding the display area DA.

The transmissive area TA may be located inside (e.g., entirely within a footprint of) the display area DA. According to some embodiments, the transmissive area TA may be arranged on the upper center of the display area DA as shown in FIG. 1. According to some embodiments, the transmissive area TA may be arranged on the upper left side or the upper right side of the display area DA. However, various modifications may be made. In a plan view of the present specification, "left," "right," "up," and "down" denote directions when the electronic apparatus 1 is viewed in a direction perpendicular to the electronic apparatus 1. As an example, "left" denotes a -x direction, "right" denotes a +x direction, "up" denotes a +y direction, and "down" denotes a -y direction. Although it is shown in FIG. 1 that one transmissive area TA is arranged or utilized within the display area DA, according to some embodiments, a plurality of transmissive areas TA may be arranged or utilized within the display area DA.

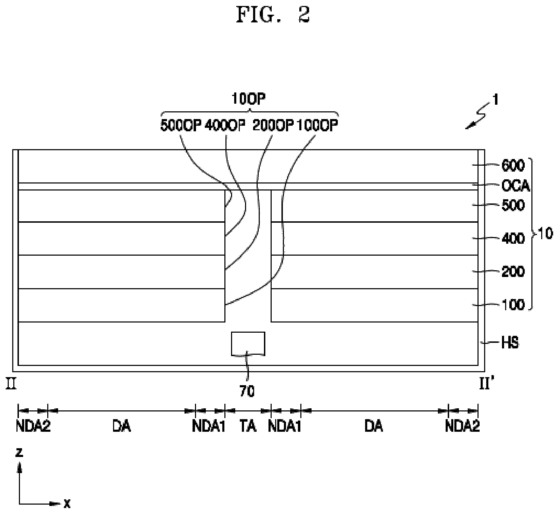

FIG. 2 is a schematic cross-sectional view of a display panel 10, taken along the line II-II' of FIG. 1, according to some embodiments.

Referring to FIG. 2, the electronic apparatus 1 may include the display panel 10 and a component 70 arranged in the transmissive area TA of the display panel 10. The display panel 10 and the component 70 may be received in a housing HS.

The display panel 10 may include a substrate 100, a display layer 200, an input sensing layer 400, an optical functional layer 500, and a cover window 600.

The display layer 200 may include light-emitting elements configured to emit light to display images, and circuit elements electrically connected to the light-emitting elements and including transistors.

The input sensing layer 400 may be configured to obtain coordinate information corresponding to an external input, for example, a touch event. The input sensing layer 400 may include a sensing electrode (or a touch electrode) and trace lines connected to the sensing electrode. The input sensing layer 400 may be located on the display layer 200. The input sensing layer 400 may sense an external input by using a self-capacitance method and/or a mutual capacitance method.

The input sensing layer 400 may be directly formed on the display layer 200, or separately formed and then coupled to the display layer 200 by using an optically clear adhesive. As an example, the input sensing layer 400 may be successively formed after a process of forming the display layer 200. In this case, an adhesive layer may not be located between the input sensing layer 400 and the display layer 200. Although it is shown in FIG. 2 that the input sensing layer 400 is located between the display layer 200 and the optical functional layer 500, the input sensing layer 400 may be located on the optical functional layer 500 according to some embodiments.

The optical functional layer 500 may include an anti-reflection layer. The anti-reflection layer may reduce the reflectivity of light (external light) incident toward the display panel 10 from the outside through the cover window 600. The anti-reflection layer may include a phase retarder and a polarizer.

According to some embodiments, the anti-reflection layer may include a black matrix and color filters. The color filters may be arranged by taking into account colors of lights emitted respectively from the light-emitting diodes of the display layer 200. According to some embodiments, the anti-reflection layer may include a destructive interference structure. The destructive interference structure may include a first reflection layer and a second reflection layer respectively located on different layers. First-reflected light and second-reflected light respectively reflected by the first reflection layer and the second reflection layer may destructively interfere and thus the reflectivity of external light may be reduced.

The optical functional layer 500 may include a lens layer. The lens layer may improve a light output efficiency of light emitted from the display layer 200 or reduce color deviation. The lens layer may include a layer having a lens shape that is concave or convex, and/or a plurality of layers having different refractive indexes. The optical functional layer 500 may include both the anti-reflection layer and the lens layer described above, or one of the anti-reflection layer and the lens layer.

The display panel 10 may include an opening 10OP. With regard to this, it is shown in FIG. 2 that the substrate 100, the display layer 200, the input sensing layer 400, and the optical functional layer 500 respectively include first to fourth openings 100OP, 200OP, 400OP, and 500OP, and the first to fourth openings 100OP, 200OP, 400OP, and 500OP overlap one another.

The first opening 100OP may be a through hole passing through from the upper surface to the bottom surface of the substrate 100. The second opening 200OP may be a through hole passing through from the upper surface to the bottom surface of the display layer 200, the third opening 400OP may be a through hole passing through from the upper surface to the bottom surface of the input sensing layer 400, and the fourth opening 500OP may be a through hole passing through from the upper surface to the bottom surface of the optical functional layer 500. The first to fourth openings 100OP, 200OP, 400OP, and 500OP may be located in the transmissive area TA to overlap one another. The first to fourth openings 100OP, 200OP, 400OP, and 500OP may be equal to or different from one another in size (or diameter).

According to some embodiments, at least one of the substrate 100, the display layer 200, the input sensing layer 400, or the optical functional layer 500 may not include an opening. As an example, one, two, or three elements among the substrate 100, the display layer 200, the input sensing layer 400, and the optical functional layer 500 may not include an opening.

The cover window 600 may be located on the optical functional layer 500. The cover window 600 may be coupled to the optical functional layer 500 by an adhesive layer OCA such as a transparent optical clear adhesive. The cover window 600 may include glass or plastic. The plastic may include polyethersulfone, polyacrylate, polyetherimide, polyethylene naphthalate, polyethylene terephthalate, polyphenylene sulfide, polyarylate, polyimide, polycarbonate, or cellulose acetate propionate.

The cover window 600 may include a flexible window. As an example, the cover window 600 may include a polyimide window or an ultra-thin glass window.

The transmissive area TA may be a kind of component area (e.g., a sensor region, a camera region, a speaker region, and the like) in which the component 70 for adding various functions to the electronic apparatus 1 is located. The component 70 may overlap an opening 10OP of the display panel 10.

The component 70 may include an electronic element. As an example, the component 70 may be an electronic element that uses light or sound. As an example, the electronic element may include a sensor such as an infrared sensor that uses light, a camera that receives light to capture an image, a sensor that outputs and senses light or sound to measure a distance or recognize a fingerprint, a small lamp that outputs light, and a speaker that outputs sound. The electronic element that uses light may use light in various wavelength bands such as visible light, infrared light, ultraviolet light and the like. Light and/or sound output from the component 70 to the outside or progressing toward the component 70 from the outside may travel through the transmissive area TA.

According to some embodiments, in the case where the electronic apparatus 1 is used as a smartwatch or an instrument panel for an automobile, the component 70 may be a member such as clock hands or a needle indicating information (e.g., set or predetermined information) (e.g., the velocity of a vehicle, and the like). In this case, unlike FIG. 2, the cover window 600 may include an opening located in the transmissive area TA such that the component 70 such as a needle is exposed to the outside. Alternatively, even in the case where the electronic apparatus 1 includes the component 70 such as a speaker, the cover window 600 may include an opening corresponding to the transmissive area TA.

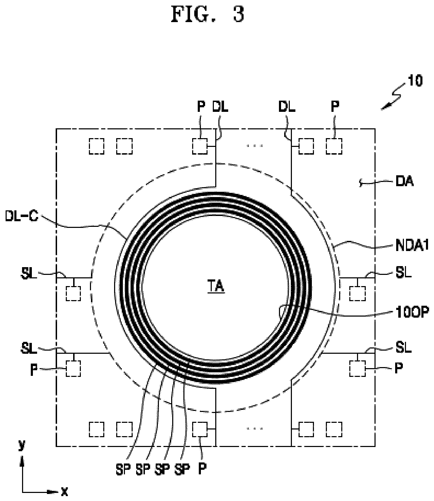

FIG. 3 is a plan view of a portion of the display panel 10 according to some embodiments.

FIG. 3 shows the transmissive area TA of the display panel 10, the first non-display area NDA1 surrounding the transmissive area TA, and the display area DA surrounding the first non-display area NDA1.

Sub-pixels P may be arranged in the display area DA. The sub-pixels P may be arranged in the display area DA to surround the transmissive area TA and the first non-display area NDA1. The sub-pixel P is a minimum area from which light is emitted and is a region from which red, green, or blue light is emitted. Light may be emitted from a light-emitting element, for example, a light-emitting diode. The position of the sub-pixel P may correspond to the position of the light-emitting diode. When the sub-pixel P is arranged in the display area DA, it may represent that the light-emitting diode is arranged in the display area DA. A sub-pixel P may be connected to a data line DL extending in the y direction and a scan line SL extending in the x direction. Data lines DL arranged adjacent to the first non-display area NDA1 may be connected to each other through a data connection line DL-C extending bypass the transmissive area TA in the first non-display area NDA1.

The sub-pixels P and/or the light-emitting diodes adjacent to the transmissive area TA may be apart from each other around the transmissive area TA in a plan view. The light-emitting diodes may be vertically spaced apart from each other around the transmissive area TA, or horizontally spaced apart from each other around the transmissive area TA (e.g., in a plan view).

Separators SP may be arranged in the first non-display area NDA1 to be apart from each other. In other words, the separators SP may be apart from each other between the display area DA and the transmissive area TA, or between the display area DA and the opening 10OP. Each of the separators SP may have a closed loop shape in a plan view (e.g., when viewed in a direction perpendicular or normal with respect to the upper surface of the substrate). According to some embodiments, as shown in FIG. 3, the separators SP may be arranged concentrically in a plan view.

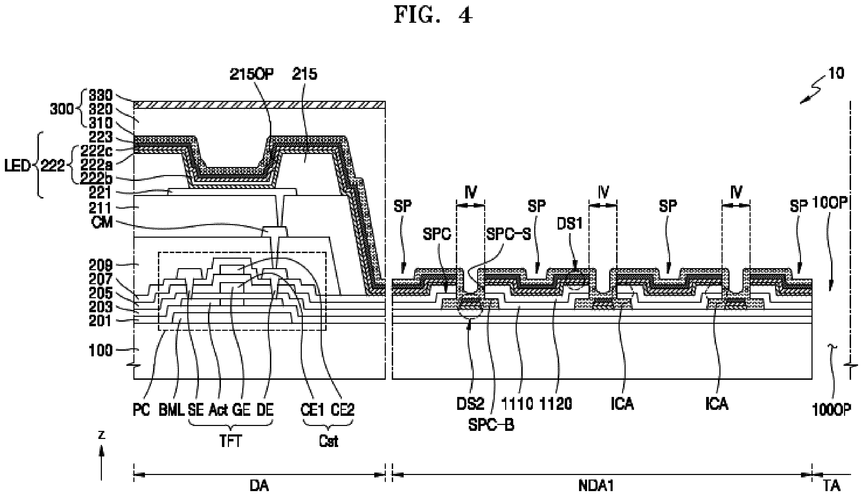

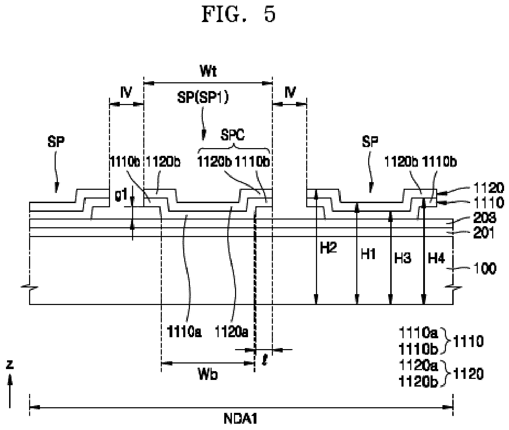

FIG. 4 is a cross-sectional view of a portion of the display panel 10 according to some embodiments, and FIG. 5 is a schematic cross-sectional view of the separators SP of the display panel 10 shown in FIG. 4 according to some embodiments.

Referring to FIG. 4, the display panel 10 may include the opening 10OP passing through the display panel 10 and arranged in the transmissive area TA. The substrate 100 of the display panel 10 may include the first opening 100OP of the substrate 100, wherein the first opening 100OP is located in and overlaps the transmissive area TA and corresponds to the opening 10OP of the display panel 10.

Referring to the display area DA of FIG. 4, a sub-pixel circuit PC may be located over the substrate 100, and a light-emitting diode LED may be located on the sub-pixel circuit PC.

The substrate 100 may include glass or polymer resin. As an example, the polymer resin may include polyethersulfone, polyacrylate, polyetherimide, polyethylene naphthalate, polyethylene terephthalate, polyphenylene sulfide, polyarylate, polyimide, polycarbonate, cellulose acetate propionate, or the like. The substrate 100 including the polymer resin may be flexible, rollable, or bendable. The substrate 100 may have a multi-layered structure including a layer that includes the polymer resin and an inorganic insulating layer.

A buffer layer 201 may be located on the upper surface of the substrate 100. A bottom metal layer BML may be formed on the substrate 100 before the buffer layer 201 is formed. The bottom metal layer BML may overlap a thin-film transistor TFT described below and be electrically connected to a voltage line electrically connected to the thin-film transistor TFT or one of electrodes of the thin-film transistor TFT. The bottom metal layer BML may include a conductive material (e.g., a metal material) including molybdenum (Mo), aluminum (Al), copper (Cu), titanium (Ti), or the like.

The buffer layer 201 may prevent impurities from penetrating a semiconductor layer Act of the thin-film transistor TFT. The buffer layer 201 may include an inorganic insulating material such as silicon nitride, silicon oxynitride, and silicon oxide, and include a single layer or a multi-layer including the above inorganic insulating materials.

The sub-pixel circuit PC may be located on the buffer layer 201. The sub-pixel circuit PC includes the thin-film transistor TFT and a storage capacitor Cst. The thin-film transistor TFT may include the semiconductor layer Act, a gate electrode GE, a source electrode SE, and a drain electrode DE. Although FIG. 4 shows a top-gate type thin-film transistor in which the gate electrode GE is located on the semiconductor layer Act with a gate insulating layer 203 therebetween, the thin-film transistor TFT may be a bottom-gate type thin-film transistor according to some embodiments.

The semiconductor layer Act may include polycrystalline silicon. Alternatively, the semiconductor layer Act may include amorphous silicon, an oxide semiconductor, or an organic semiconductor. The gate electrode GE may include a low-resistance metal material. The gate electrode GE may include a conductive material (e.g., a metal material) including molybdenum (Mo), aluminum (Al), copper (Cu), and titanium (Ti) and have a single-layered structure or a multi-layered structure including the above materials.

The gate insulating layer 203 between the semiconductor layer Act and the gate electrode GE may include an inorganic insulating material including silicon oxide, silicon nitride, silicon oxynitride, aluminum oxide, titanium oxide, tantalum oxide, hafnium oxide and the like. The gate insulating layer 203 may include a single layer or a multi-layer including the above materials.

The source electrode SE and the drain electrode DE may each include a material having high conductivity. The source electrode SE and the drain electrode DE may each include a conductive material (e.g., a metal material) including molybdenum (Mo), aluminum (Al), copper (Cu), and titanium (Ti) and include a single layer or a multi-layer including the above materials. According to some embodiments, the source electrode SE and the drain electrode DE may be formed in a multi-layered structure of a titanium layer, an aluminum layer, and a titanium layer (Ti/AI/Ti).

The storage capacitor Cst may include a lower electrode CE1 and an upper electrode CE2 overlapping each other with a first interlayer insulating layer 205 therebetween. The storage capacitor Cst may overlap the thin-film transistor TFT. With regard to this, it is shown in FIG. 4 that the gate electrode GE of the thin-film transistor TFT serves as the lower electrode CE1 of the storage capacitor Cst. According to some embodiments, the storage capacitor Cst may not overlap the thin-film transistor TFT, and the gate electrode GE of the thin-film transistor TFT and the lower electrode CE1 of the storage capacitor Cst may be formed separately. The storage capacitor Cst may be covered by a second interlayer insulating layer 207, and the source electrode SE and the drain electrode DE may be located on the second interlayer insulating layer 207.

The lower electrode CE1 and/or the upper electrode CE2 of the storage capacitor Cst may include a conductive material (e.g., a metal material) including molybdenum (Mo), aluminum (Al), copper (Cu), titanium (Ti), and the like, and include a multi-layer or a single layer including the above materials.

The first interlayer insulating layer 205 and the second interlayer insulating layer 207 may each include an inorganic insulating material including silicon oxide, silicon nitride, silicon oxynitride, aluminum oxide, titanium oxide, tantalum oxide, hafnium oxide and the like. The first interlayer insulating layer 205 and the second interlayer insulating layer 207 may each include a single layer or a multi-layer including the above materials.

The sub-pixel circuit PC including the thin-film transistor TFT and the storage capacitor Cst may be covered by a first organic insulating layer 209.

A first electrode 221 may be located on the sub-pixel circuit PC, and the first electrode 221 of the light-emitting diode LED may be electrically connected to the sub-pixel circuit PC. As an example, as shown in FIG. 4, a contact metal layer CM may be located between the thin-film transistor TFT and the first electrode 221. The contact metal layer CM may be connected to the thin-film transistor TFT through a contact hole formed in the first organic insulating layer 209. The first electrode 221 may be located on a second organic insulating layer 211 and connected to the contact metal layer CM through a contact hole formed in the second organic insulating layer 211. The contact metal layer CM may include a conductive material (e.g., a metal material) including molybdenum (Mo), aluminum (Al), copper (Cu), and titanium (Ti) and have a single-layered structure or a multi-layered structure including the above materials. According to some embodiments, the contact metal layer CM may include a multi-layer of Ti/AI/Ti.

The first organic insulating layer 209 and the second organic insulating layer 211 may include an organic insulating material including a general-purpose polymer such as polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a blend thereof. According to some embodiments, the first organic insulating layer 209 and the second organic insulating layer 211 may each include polyimide.

The first electrode 221 may be formed on the second organic insulating layer 211. The first electrode 221 may include a conductive oxide such as indium tin oxide (ITO), indium zinc oxide (IZO), zinc oxide (ZnO), indium oxide (In₂O₃), indium gallium oxide (IGO), or aluminum zinc oxide (AZO). According to some embodiments, the first electrode 221 may include a reflective layer including silver (Ag), magnesium (Mg), aluminum (Al), platinum (Pt), palladium (Pd), gold (Au), nickel (Ni), neodymium (Nd), iridium (Ir), chrome (Cr), or a compound thereof. According to some embodiments, the first electrode 221 may further include a layer on/under the reflective layer, the layer including ITO, IZO, ZnO, or In₂O₃. According to some embodiments, the first electrode 221 may have a triple-layered structure of ITO/Ag/ITO.

A bank layer 215 may be located on the first electrode 221. The bank layer 215 may include an opening that exposes a portion of the first electrode 221 and cover the edges of the first electrode 221. The bank layer 215 may define the sub-pixel. As an example, the width of an opening 215OP exposing the upper surface of the first electrode 221 may correspond to the width of the emission area from which light is emitted, that is, the width of the sub-pixel.

The bank layer 215 may include an organic insulating material. As an example, the bank layer 215 may include an organic insulating material including a general-purpose polymer such as polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a blend thereof.

An intermediate layer 222 includes an emission layer 222b. The emission layer 222b may include a polymer organic material or a low-molecular weight organic material configured to emit light having a preset color. The intermediate layer 222 may include at least one functional layer. The at least one functional layer may include an organic material. As shown in FIG. 4, the intermediate layer 222 may include a first functional layer 222a and/or a second functional layer 222c, wherein the first functional layer 222a is under the emission layer 222b, and the second functional layer 222c is on the emission layer 222b. The first functional layer 222a and/or the second functional layer 222c may include an organic material layer including an organic material.

The first functional layer 222a may include a single layer or a multi-layer. As an example, the first functional layer 222a includes a polymer material, the first functional layer 222a may include a hole transport layer (HTL), which has a single-layered structure. In the case where the first functional layer 222a includes a low-molecular weight material, the first functional layer 222a may include a hole injection layer (HIL) and an HTL.

The second functional layer 222c may include a single layer or a multi-layer. The second functional layer 222c may include an electron transport layer (ETL) and/or an electron injection layer (EIL).

A second electrode 223 may include a conductive material having a low work function. As an example, the second electrode 223 may include a (semi) transparent layer including silver (Ag), magnesium (Mg), aluminum (Al), platinum (Pt), palladium (Pd), gold (Au), nickel (Ni), neodymium (Nd), iridium (Ir), chrome (Cr), or an alloy thereof. Alternatively, the second electrode 223 may further include a layer on the (semi) transparent layer, the layer including ITO, IZO, ZnO, or In₂O₃. According to some embodiments, the second layer 230 may include silver (Ag) and magnesium (Mg). The second electrode 223 may cover the display area DA entirely. The second electrode 223 is a common electrode and may cover the plurality of first electrodes 221.

The light-emitting diode LED including the first electrode 221, the intermediate layer 222, and the second electrode 223 is covered by a thin-film encapsulation layer 300. The thin-film encapsulation layer 300 may include at least one organic encapsulation layer and at least one inorganic encapsulation layer. According to some embodiments, it is shown in FIG. 4 that the thin-film encapsulation layer 300 includes first and second inorganic encapsulation layers 310 and 330 and an organic encapsulation layer 320 therebetween. According to some embodiments, the number of organic encapsulation layers, the number of inorganic encapsulation layers, and a stacking order may be changed.

The first and second inorganic encapsulation layers 310 and 330 may include at least one inorganic material among aluminum oxide, titanium oxide, tantalum oxide, hafnium oxide, zinc oxide, silicon oxide, silicon nitride, silicon oxynitride, and the like. The first and second inorganic encapsulation layers 310 and 330 may include a single layer or a multi-layer including the above materials. The organic encapsulation layer 320 may include a polymer-based material. The polymer-based material may include an acryl-based resin such as polymethylmethacrylate and poly acrylic acid, an epoxy-based resin, polyimide, and polyethylene. According to some embodiments, the organic encapsulation layer 320 may include acrylate polymer.

The material of the first inorganic encapsulation layer 310 may be different from that of the second inorganic encapsulation layer 330. As an example, the first inorganic encapsulation layer 310 may include silicon oxynitride, and the second inorganic encapsulation layer 330 may include silicon nitride. The thickness of the first inorganic encapsulation layer 310 may be different from that of the second inorganic encapsulation layer 330. The thickness of the first inorganic encapsulation layer 310 may be greater than that of the second inorganic encapsulation layer 330. Alternatively, the thickness of the second inorganic encapsulation layer 330 may be greater than that of the first inorganic encapsulation layer 310, or the thickness of the first inorganic encapsulation layer 310 may be the same as that of the second inorganic encapsulation layer 330.

Referring to the first non-display area NDA1 of FIG. 4, the separators SP may be arranged apart from each other between the display area DA and the transmissive area TA (or between the light-emitting diode LED and the first opening 100OP of the substrate 100).

The separators SP may be located on the upper surface of an inorganic insulating layer. According to some embodiments, it is shown in FIG. 4 that the separators SP are arranged on the upper surface of the gate insulating layer 203 in a direction (or a direction from the display area DAT to the transmissive area TA) parallel to the upper surface of the substrate 100, with a separation region IV between adjacent separators SP.

Referring to FIGS. 4 and 5, each separator SP may have a stack structure of a plurality of inorganic insulating layers. According to some embodiments, although it is shown in FIGS. 4 and 5 that the separator SP includes two inorganic insulating layers that are stacked, the separator SP may have a stack structure of three or more inorganic insulating layers. Hereinafter, for convenience of description, the case where the separator SP has a structure in which two inorganic insulating layers are stacked is described. The separator SP may include a first inorganic insulating layer 1110 and a second inorganic insulating layer 1120 on the first inorganic insulating layer 1110. The first inorganic insulating layer 1110 and the second inorganic insulating layer 1120 of each separator SP may be separated and spaced apart from the first inorganic insulating layer 1110 and the second inorganic insulating layer 1120 of the adjacent separator SP.

The first inorganic insulating layer 1110 and the second inorganic insulating layer 1120 may include an inorganic insulating material such as silicon nitride, silicon oxynitride, and silicon oxide. According to some embodiments, the first inorganic insulating layer 1110 and the second inorganic insulating layer 1120 may include different materials. As an example, the first inorganic insulating layer 1110 may include silicon nitride, and the second inorganic insulating layer 1120 may include silicon oxynitride.

The separator SP may include a cantilever portion SPC. As an example, the separator SP may include a cantilever portion SPC extending to the display area DA and/or a cantilever portion SPC extending to the transmissive area TA. The cantilever portion SPC of the separator SP may be apart by a first gap g1 from the upper surface of the inorganic insulating layer (e.g., the gate insulating layer 203) under the separator SP in a first direction (e.g., a direction perpendicular to the upper surface of the substrate 100) away from the substrate 100, and may have a first length ℓ in a second direction crossing the first direction (e.g., a z direction). The first gap g1 may be several thousand angstroms (Å) and the first length ℓ may be about 0.2 µm to 1 µm.

In other words, the bottom surface of the separator SP having the cantilever portion SPC may be in direct contact with the upper surface of the inorganic insulating layer (e.g., the gate insulating layer 203), which is a lower layer located under the separator SP, while having a first width Wb. The first width Wb of the bottom surface of the separator SP may be less than a second width Wt of the upper surface of the separator SP.

According to some embodiments, the cantilever portion SPC of the separator SP may have a stack structure of a second portion 1110b of the first inorganic insulating layer 1110 and a second portion 1120b of the second inorganic insulating layer 1120.

A first portion 1110a of the first inorganic insulating layer 1110 may be in direct contact with the upper surface of the inorganic insulating layer thereunder, for example, the gate insulating layer 203, but the second portion 1110b, which is the edge portion of the first inorganic insulating layer 1110 corresponding to the cantilever portion SPC, may be apart by the first gap g1 from the upper surface of the inorganic insulating layer thereunder, for example, the gate insulating layer 203 in the first direction (e.g., the z direction).

A level of the upper surface of each of the cantilever portion SPC of the separator SP may be different from a level of the upper surface of a portion of the separator SP between the cantilever portions SPC. Here, a "level is different" represents that a "vertical distance from the lower surface or the upper surface of the substrate 100 in the first direction (e.g., the z direction) is different." As an example, as shown in FIG. 5, a first vertical distance H1 from the lower surface (or the upper surface) of the substrate 100 to the upper surface of the intermediate portion of the separator SP located between the cantilever portions SPC may be less than a second vertical distance H2 from the lower surface (or the upper surface) of the substrate 100 to the upper surface of the cantilever portion SPC of the separator SP. In other words, the upper surface of the separator SP may have a step difference.

According to some embodiments, the first vertical distance H1 from the lower surface of the substrate 100 to the upper surface of the first portion 1120a of the second inorganic insulating layer 1120 may be less than the second vertical distance H2 from the lower surface of the substrate 100 to the upper surface of the second portion 1120b of the second inorganic insulating layer 1120. Alternatively, a vertical distance from the upper surface (or the upper surface of the inorganic insulating layer which is located under the first inorganic insulating layer 1110 and is in direct contact with the first inorganic insulating layer 1110, for example, the upper surface of the gate insulating layer 203) of the substrate 100 to the upper surface of the first portion 1120a of the second inorganic insulating layer 1120 may be less than a vertical distance from the upper surface (or the upper surface of the inorganic insulating layer which is located under the first inorganic insulating layer 1110 and is in direct contact with the first inorganic insulating layer 1110, for example, the upper surface of the gate insulating layer 203) of the substrate 100 to the upper surface of the second portion 1120b of the second inorganic insulating layer 1120. In other words, in a cross-section, the upper surface of the second inorganic insulating layer 1120 may have a step difference.

The second inorganic insulating layer 1120 may be in direct contact with the first inorganic insulating layer 1110. The entire bottom surface of the second inorganic insulating layer 1120 may be in direct contact with the upper surface of the first inorganic insulating layer 1110. As an example, the first portion 1120a of the second inorganic insulating layer 1120 may be in direct contact with the first portion 1110a of the first inorganic insulating layer 1110, and the second portion 1120b of the second inorganic insulating layer 1120 corresponding to the cantilever portion SPC may be in direct contact with the upper surface of the first inorganic insulating layer 1110.

According to some embodiments, a third vertical distance H3 from the lower surface of the substrate 100 to the upper surface of the first portion 1110a of the first inorganic insulating layer 1110 may be less than a fourth vertical distance H4 from the lower surface of the substrate 100 to the upper surface of the second portion 1110b of the first inorganic insulating layer 1110. Alternatively, a vertical distance from the upper surface (or the upper surface of the inorganic insulating layer which is located under the first inorganic insulating layer 1110 and is in direct contact with the first inorganic insulating layer 1110, for example, the upper surface of the gate insulating layer 203) of the substrate 100 to the upper surface of the first portion 1110a of the first inorganic insulating layer 1110 may be less than a vertical distance from the upper surface (or the upper surface of the inorganic insulating layer which is located under the first inorganic insulating layer 1110 and is in direct contact with the first inorganic insulating layer 1110, for example, the upper surface of the gate insulating layer 203) of the substrate 100 to the upper surface of the second portion 1110b of the first inorganic insulating layer 1110. In other words, in a cross-section, the upper surface of the first inorganic insulating layer 1110 may have a step difference.

According to some embodiments, although some of the separators SP arranged in the first non-display area NDA1 may include the symmetrical cantilever portions SPC on two opposite sides as in a first separator SP1 shown in FIG. 5, others may include the cantilever portion SPC on one side. As an example, as shown in FIG. 4, the separator SP arranged most adjacent to the transmissive area TA among the separators SP, and the separator SP arranged relatively adjacent to the display area DA among the separators SP may include one cantilever portion SPC.

The first functional layer 222a and/or the second functional layer 222c, which are organic material layers formed in the display area DA of FIG. 4 may be also deposited in the first non-display area NDA1. An organic material may serve as a progression path of moisture. As shown in FIG. 4, in the case where external moisture is introduced through the opening 10OP of the display panel 10 or the first opening 100OP of the substrate 100, the light-emitting diode LED may be damaged. In contrast, according to some embodiments, because the separators SP described with reference to FIGS. 4 and 5 are arranged in the first non-display area NDA1, the first functional layer 222a and/or the second functional layer 222c may be discontinuously arranged in the first non-display area NDA1.

When depositing the first functional layer 222a and/or the second functional layer 222c, a material forming each of the first functional layer 222a and/or the second functional layer 222c may be discontinuously deposited by the cantilever portion SPC of the separator SP. Accordingly, as shown in FIG. 4, the first functional layer 222a and/or the second functional layer 222c may include a first portion and a second portion, wherein the first portion is located on the upper surface of the separator SP, and the second portion is arranged in the separation region IV between the separator SP and the separator SP. The first portion and the second portion may be separated from each other.

Similarly to the first functional layer 222a and/or the second functional layer 222c, the second electrode 223 of the light-emitting diode LED may also include portions discontinuously arranged in the first non-display area NDA1. As an example, a first portion of the second electrode 223 located on the upper surface of the separator SP and a second portion of the second electrode 223 arranged in the separation region IV between the adjacent separators SP are separated from each other.

In other words, a stack body (referred to as a first dummy stack body DS1) of the first functional layer 222a, the second functional layer 222c, and the second electrode 223 located on the upper surface of the separator SP is separated from a stack body (referred to as a second dummy stack body DS2) of the first functional layer 222a, the second functional layer 222c, and the second electrode 223 located in the separation region IV.

The first functional layer 222a and/or the second functional layer 222c, and the second electrode 223 separated by the separator SP may be covered by the inorganic encapsulation layer. As an example, as shown in FIG. 4, the first inorganic encapsulation layer 310 may cover the first functional layer 222a and/or the second functional layer 222c, and the second electrode 223 separated by the separator SP. Unlike the first functional layer 222a, the second functional layer 222c, and the second electrode 223, because the first inorganic encapsulation layer 310 has a relatively excellent step coverage, the first inorganic encapsulation layer 310 may be continuous in the first non-display area NDA1. The first inorganic encapsulation layer 310 may be in direct contact with a portion of the separator SP to form an inorganic contact portion ICA. As an example, the first inorganic encapsulation layer 310 may be in direct contact with a lateral surface SPC-S and/or a lower surface SPC-B of the cantilever portion SPC of the separator SP to form the inorganic contact portion ICA.

As described above, the first dummy stack body DS1 located on the upper surface of the separator SP is separated from the second dummy stack body DS2 located in the separation region IV. The first dummy stack body DS1 is located on the separator SP, and the inorganic contact portions ICA may be located on two opposite sides of the separator SP. The first dummy stack body DS1 is located on the separator SP, and the inorganic contact portions ICA may be located on two opposite sides with the second dummy stack body DS2 therebetween. In other words, the first dummy stack body DS1 located on the separator SP may be disconnected from the second dummy stack body DS2 in the separation region IV with the inorganic contact portion ICA therebetween. The inorganic contact portion ICA, which is a contact region between the inorganic insulating materials, may be configured to block moisture transmission more effectively. Because the inorganic contact portion ICA is not located in a separate region (e.g., the separate region IV) between the separator SP and the separator SP but is located on the cantilever portion SPC of the separator SP as shown in FIG. 4, a separate space for securing the inorganic contact portion ICA is not required. Accordingly, the width of the first non-display area NDA1 may be reduced. According to some embodiments, some of the separators SP may overlap the organic encapsulation layer 320.

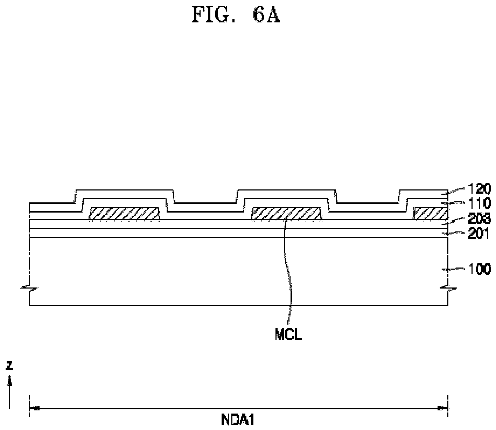

FIGS. 6A to 6C are schematic cross-sectional views showing a process of forming a separator SP of the display panel 10 according to some embodiments.

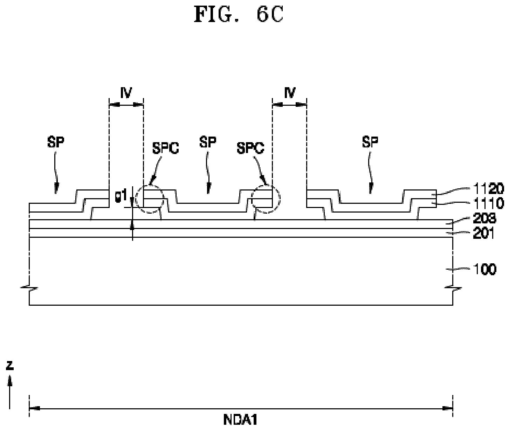

Referring to FIG. 6A, a sacrificial layer MCL is formed on the substrate 100. Although, before forming the sacrificial layer MCL, two lower layers, for example, the buffer layer 201 and the gate insulating layer 203 may be formed, the embodiments according to the present disclosure are not limited thereto. According to some embodiments, a separate lower layer is not formed on the substrate 100. In this case, the lower layer under the separator SP shown in FIG. 6C may be the substrate 100. According to some embodiments, the substrate 100 may include a stack structure of an inorganic barrier layer including a polymer resin layer and an inorganic insulating material on the polymer resin layer. In this case, the lower layer under the separator SP may be the inorganic barrier layer of the substrate 100.

The sacrificial layer MCL may include a conductive material (e.g., a metal material). As an example, the sacrificial layer MCL may be formed simultaneously with one of the electrodes (e.g., the gate electrode, the source electrode, or the drain electrode) and the bottom metal layer BML described with reference to FIG. 4 during the same process as a process of forming one of the electrodes and the bottom metal layer BML, and may include the same material as a material of one of the electrodes and the bottom metal layer BML.

The sacrificial layer MCL may be arranged in the first non-display area NDA1 to be apart from another adjacent sacrificial layer MCL. After that, a first inorganic insulating material layer 110 may be formed on the sacrificial layer MCL, and a second inorganic insulating material layer 120 may be formed on the first inorganic insulating material layer 110.

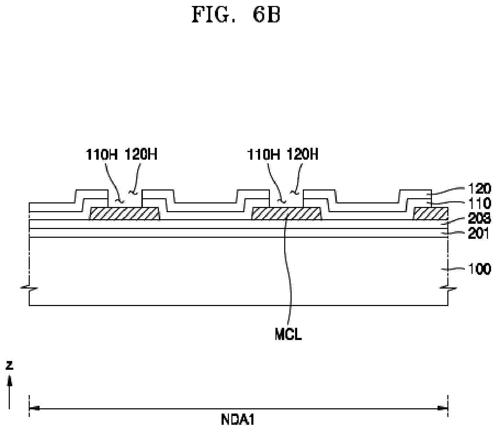

Referring to FIG. 6B, a hole 110H of the first inorganic insulating material layer 110 and a hole 120H of the second inorganic insulating material layer 120 each overlapping the sacrificial layer MCL are formed by etching a portion of the first inorganic insulating material layer 110 and a portion of the second inorganic insulating material layer 120 through an etching process. The upper surface of the sacrificial layer MCL may be exposed through the hole 110H of the first inorganic insulating material layer 110 and the hole 120H of the second inorganic insulating material layer 120.

Referring to FIG. 6C, the sacrificial layer MCL may be removed through the etching process. The etching process of removing the sacrificial layer MCL may be different from the etching process of forming the hole 110H of the first inorganic insulating material layer 110 and the hole 120H of the second inorganic insulating material layer 120. As an example, the sacrificial layer MCL may be removed by wet etching, and the hole 110H of the first inorganic insulating material layer 110 and the hole 120H of the second inorganic insulating material layer 120 may be formed by dry etching. The dry etching and the wet etching may be etching processes performed during a process of forming the thin-film transistor TFT and the light-emitting diode LED described with reference to FIG. 4.

While the sacrificial layer MCL is removed, the cantilever portion SPC may be formed, wherein the cantilever portion SPC has the first gap g1 from the upper surface of the gate insulating layer 203, which is the lower layer located under the sacrificial layer MCL. The separator SP may be apart from the adjacent separator SP by the separation region IV. The separator SP may have a stack structure of the first inorganic insulating layer 1110 and the second inorganic insulating layer 1120.

Although it is shown in FIG. 6C that the sacrificial layer present under the separator SP is completely removed and there is no residue below the cantilever portion SPC of the separator SP, the embodiments according to the present disclosure are not limited thereto.

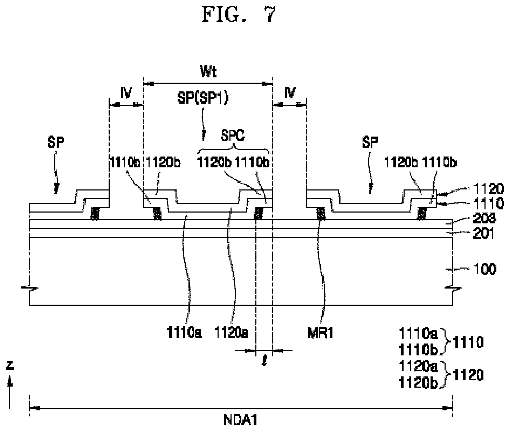

FIG. 7 is a schematic cross-sectional view of separators arranged in a first non-display area NDA1 of a display panel 10 according to some embodiments. Referring to FIG. 7, a first metal residue MR1 may be present below the cantilever portion SPC of the separator SP. The first metal residue MR1 may correspond to a portion of the sacrificial layer not removed during the etching process described above with reference to FIGS. 6A to 6C. The first metal residue MR1 may have a width less than the first length ℓ of the cantilever portion SPC.

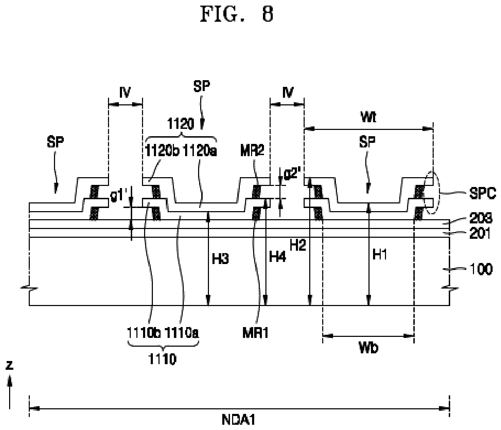

FIG. 8 is a schematic cross-sectional view of separators SP arranged in the first non-display area NDA1 of the display panel 10 according to some embodiments.

Referring to FIG. 8, as described above with reference to FIGS. 4 and 5, the separator SP may include the stack structure of the plurality of inorganic insulating layers, for example, the first inorganic insulating layer 1110 and the second inorganic insulating layer 1120 on the first inorganic insulating layer 1110. The specific materials thereof are the same as described above.

The separator SP may include a cantilever portion SPC. The bottom surface of the separator SP may be in direct contact with the upper surface of the inorganic insulating layer (e.g., the gate insulating layer 203), which is the lower layer located under the separator SP. The first width Wb of the bottom surface of the separator SP may be less than a second width Wt of the upper surface of the separator SP.

Unlike each of the cantilever portions SPC located on two opposite sides of the separator SP has a single eaves structure in the embodiments described with reference to FIGS. 4 and 5, each cantilever portion SPC may have a structure in which a plurality of cantilever portions overlap each other according to some embodiments as shown in FIG. 8. As an example, the cantilever portion SPC may have a structure in which the second portion 1110b of the first inorganic insulating layer 1110 and the second portion 1120b of the second inorganic insulating layer 1120 overlap each other, wherein the second portion 1110b has a first gap g1' in the first direction (e.g., the z direction) from the upper surface of the inorganic insulating layer (e.g., the gate insulating layer 203), which is the lower layer located under the separator SP, and the second portion 1120b has a second gap g2' in the first direction (e.g., the z direction) from the second portion 1110b of the first inorganic insulating layer 1110.

A first portion 1110a of the first inorganic insulating layer 1110 may be in direct contact with the upper surface of the inorganic insulating layer thereunder, for example, the gate insulating layer 203, but the second portion 1110b of the first inorganic insulating layer 1110 corresponding to the cantilever portion SPC, may be apart in the first direction (e.g., the z direction) by the first gap g1' from the upper surface of the inorganic insulating layer thereunder, for example, the gate insulating layer 203. Although the first portion 1120a of the second inorganic insulating layer 1120 may be in direct contact with the upper surface of the first inorganic insulating layer 1110 thereunder, the second portion 1120b of the second inorganic insulating layer 1120 corresponding to the cantilever portion SPC may be apart in the first direction (e.g., the z direction) by the second gap g2' from the upper surface of the second portion 1110b of the first inorganic insulating layer 1110 therebelow. Only a portion of the bottom surface of the second inorganic insulating layer 1120 may be in direct contact with the upper surface of the first inorganic insulating layer 1110.

The first gap g1' and the second gap g2' may correspond to the positions on which the sacrificial layer is utilized (or formed) as in the process described above with reference to FIGS. 6A to 6C. According to some embodiments, in the case where the sacrificial layer is not completely removed through the etching process, there may be the metal residue below the cantilever portion SPC as shown in FIG. 8. As an example, the first metal residue MR1 may be present under the second portion 1110b of the first inorganic insulating layer 1110. Similarly, a second metal residue MR2 may be present under the second portion 1120b of the second inorganic insulating layer 1120.

According to some embodiments, the first vertical distance H1 from the lower surface of the substrate 100 to the upper surface of the first portion 1120a of the second inorganic insulating layer 1120 may be less than the second vertical distance H2 from the lower surface of the substrate 100 to the upper surface of the second portion 1120b of the second inorganic insulating layer 1120 as described above. Similarly, a third vertical distance H3 from the lower surface of the substrate 100 to the upper surface of the first portion 1110a of the first inorganic insulating layer 1110 may be less than a fourth vertical distance H4 from the lower surface of the substrate 100 to the upper surface of the second portion 1110b of the first inorganic insulating layer 1110.

According to some embodiments, as described above with reference to FIG. 4, the first dummy stack body DS1 (see FIG. 4) located on the upper surface of the separator SP may be separated from the second dummy stack body DS2 (see FIG. 4) located in the separation region IV. The first inorganic encapsulation layer 310 (see FIG. 4) described with reference to FIG. 4 may be also formed on the separator SP shown in FIG. 8, and may be in contact with the lateral surface and/or the lower surface of the cantilever portion SPC to form an inorganic contact portion.

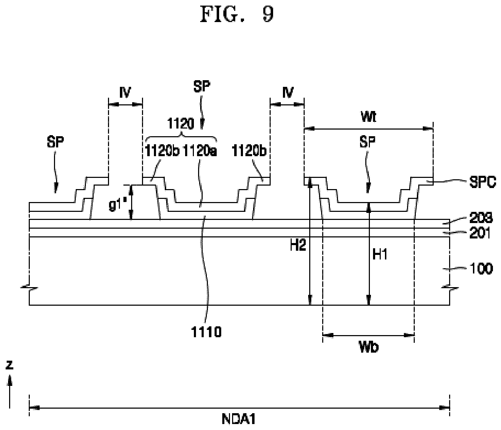

FIG. 9 is a schematic cross-sectional view of the separators SP arranged in the first non-display area NDA1 of the display panel 10 according to some embodiments.

Referring to FIG. 9, as described above with reference to FIGS. 4 and 5, the separator SP may include the stack structure of the plurality of inorganic insulating layers, for example, the first inorganic insulating layer 1110 and the second inorganic insulating layer 1120 on the first inorganic insulating layer 1110. The specific materials thereof are the same as described above.

The separator SP may include a cantilever portion SPC. The bottom surface of the separator SP having the cantilever portion SPC may be in direct contact with the upper surface of the inorganic insulating layer (e.g., the gate insulating layer 203), which is a lower layer located under the separator SP, while having a first width Wb. The first width Wb of the bottom surface of the separator SP may be less than a second width Wt of the upper surface of the separator SP.

Unlike the cantilever portion SPC of the separator SP has the plurality of layers according to some embodiments as described with reference to FIGS. 4 and 5, the cantilever portion SPC may have a single layer according to some embodiments as shown in FIG. 9. As an example, the second portion 1120b of the second inorganic insulating layer 1120 having a first gap g1" in the first direction (e.g., the z direction) from the upper surface of the inorganic insulating layer (e.g., the gate insulating layer 203), which is the lower layer located under the separator SP, may correspond to the cantilever portion SPC.

Although the first portion 1120a of the second inorganic insulating layer 1120 may be in direct contact with the entire upper surface of the first inorganic insulating layer 1110 thereunder, the second portion 1120b of the second inorganic insulating layer 1120 corresponding to the cantilever portion SPC may be apart in the first direction (e.g., the z direction) by a first gap g1" from the upper surface of the inorganic insulating layer (e.g., the gate insulating layer 203), which is the lower layer located under the separator SP. The width of the bottom surface of the second inorganic insulating layer 1120 may be greater than the width of the upper surface of the first inorganic insulating layer 1110, and only a portion of the bottom surface of the second inorganic insulating layer 1120 may be in direct contact with the entire upper surface of the first inorganic insulating layer 1110.

The first gap g1" may correspond to the position on which the sacrificial layer is utilized (or formed) as in the process described above with reference to FIGS. 6A to 6C. According to some embodiments, in the case where the sacrificial layer is not completely removed during the etching process, there may be a metal residue under the cantilever portion SPC.

According to some embodiments, the first vertical distance H1 from the lower surface of the substrate 100 to the upper surface of the first portion 1120a of the second inorganic insulating layer 1120 may be less than the second vertical distance H2 from the lower surface of the substrate 100 to the upper surface of the second portion 1120b of the second inorganic insulating layer 1120 as described above.

According to some embodiments, as described above with reference to FIG. 4, the first dummy stack body DS1 (see FIG. 4) located on the upper surface of the separator SP may be separated from the second dummy stack body DS2 (see FIG. 4) located in the separation region IV. The first inorganic encapsulation layer 310 (see FIG. 4) described with reference to FIG. 4 may be also formed on the separator SP shown in FIG. 9, and may be in contact with the lateral surface and/or the lower surface of the cantilever portion SPC to form an inorganic contact portion.

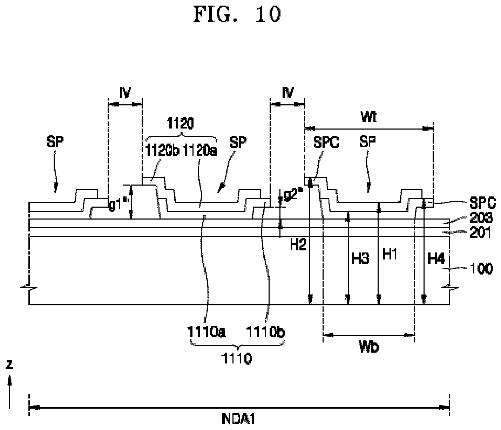

FIG. 10 is a schematic cross-sectional view of the separators SP arranged in the first non-display area NDA1 of the display panel 10 according to some embodiments.

Referring to FIG. 10, as described above with reference to FIGS. 4 and 5, the separator SP may include the stack structure of the plurality of inorganic insulating layers, for example, the first inorganic insulating layer 1110 and the second inorganic insulating layer 1120 on the first inorganic insulating layer 1110. The specific materials thereof are the same as described above.

The separator SP may include a cantilever portion SPC. The bottom surface of the separator SP having the cantilever portion SPC may be in direct contact with the upper surface of the inorganic insulating layer (e.g., the gate insulating layer 203), which is a lower layer located under the separator SP, while having the first width Wb. The first width Wb of the bottom surface of the separator SP may be less than a second width Wt of the upper surface of the separator SP in the first direction (e.g., the z direction) therefrom.

Unlike the cantilever portion SPC of the separator SP has a symmetrical structure in the second direction (e.g., a horizonal direction) according to some embodiments as described with reference to FIGS. 4 to 9, the cantilever portion SPC may have an asymmetrical structure in the second direction (e.g., the horizontal direction) according to some embodiments as shown in FIG. 10. As an example, a gap of one of the cantilever portions SPC of the separator SP may be different from a gap of another of the cantilever portions SPC. As an example, a first gap g1‴ of one of the cantilever portions SPC in the first direction (e.g., the z direction) from the upper surface of the inorganic insulating layer (e.g., the gate insulating layer 203), which is the lower layer located under the separator SP, may be greater than a second gap g2‴ of another cantilever portion SPC.

The one of the cantilever portions SPC may include the second portion 1120b of the second inorganic insulating layer 1120. In other words, the second portion 1120b of the second inorganic insulating layer 1120 may protrude in the second direction from the first portion 1120a that is in contact with the upper surface of the first inorganic insulating layer 1110 to form one of the cantilever portions SPC. The second portion 1120b of the second inorganic insulating layer 1120 does not overlap the first inorganic insulating layer 1110.

The other of the cantilever portions SPC may include the second portion 1110b of the first inorganic insulating layer 1110. In other words, the second portion 1110b of the first inorganic insulating layer 1110 may protrude in the second direction from the first portion 1110a that is in contact with the bottom surface of the second inorganic insulating layer 1120 to form the other of the cantilever portions SPC. The second portion 1110b of the first inorganic insulating layer 1110 may not overlap the second inorganic insulating layer 1120. Alternatively, unlike the illustration of FIG. 10, the second portion 1110b of the first inorganic insulating layer 1110 may overlap the second inorganic insulating layer 1120.

The first gap g1‴ and the second gap g2‴ may correspond to the positions on which the sacrificial layer is utilized (or formed) as in the process described above with reference to FIGS. 6A to 6C. According to some embodiments, in the case where the sacrificial layer is not completely removed during the etching process, there may be a metal residue under the cantilever portion SPC.

According to some embodiments, the first vertical distance H1 from the lower surface of the substrate 100 to the upper surface of the first portion 1120a of the second inorganic insulating layer 1120 may be less than the second vertical distance H2 from the lower surface of the substrate 100 to the upper surface of the second portion 1120b of the second inorganic insulating layer 1120. The third vertical distance H3 from the lower surface of the substrate 100 to the upper surface of the first portion 1110a of the first inorganic insulating layer 1110 may be less than the fourth vertical distance H4 from the lower surface of the substrate 100 to the upper surface of the second portion 1110b of the first inorganic insulating layer 1110.

According to some embodiments, as described above with reference to FIG. 4, the first dummy stack body DS1 (see FIG. 4) located on the upper surface of the separator SP may be separated from the second dummy stack body DS2 (see FIG. 4) located in the separation region IV. The first inorganic encapsulation layer 310 (see FIG. 4) described with reference to FIG. 4 may be also formed on the separator SP shown in FIG. 10, and may be in contact with the lateral surface and/or the lower surface of the cantilever portion SPC to form an inorganic contact portion.

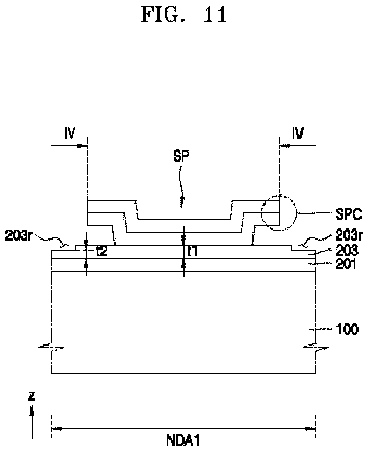

FIG. 11 is a schematic cross-sectional view of separators of the display panel 10 and a neighboring portion thereof according to some embodiments.

Referring to FIG. 11, the separation regions IV may be respectively arranged on two opposite sides around the separator SP, and the separation region IV may correspond to the position of the sacrificial layer described above with reference to FIGS. 6A to 6C. The lower layer present under the separator SP may be partially etched during the process (e.g., the process of etching the sacrificial layer) of manufacturing the display panel to form a recess. With regard to this, it is shown in FIG. 11 that the gate insulating layer 203 present under the separator SP includes a recess 203r. A first thickness t1 of a portion of the gate insulating layer 203 under the bottom surface of the separator SP may be greater than a second thickness t2 of another portion of the gate insulating layer 203 overlapping the recess 203r.

According to the embodiments, moisture transmission through the opening may be effectively prevented by the separator having the cantilever structure, and because the inorganic contact portion is formed on the separator, the width of the first non-display area may be relatively reduced. However, this effect is provided as an example, and effects according to embodiments are described in detail in the above description.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims, and their equivalents.

## Claims

1. A display panel (10) comprising:
a substrate (100) including an opening (100OP) passing through an upper surface thereof and a lower surface thereof;
a light-emitting diode (LED) arranged in a display area (DA) around the opening (100OP) and comprising a first electrode (221), a second electrode (223), and an intermediate layer (222) between the first electrode (221) and the second electrode (223);
a thin-film encapsulation layer (300) on the light-emitting diode (LED) and comprising an organic encapsulation layer (320) and at least one inorganic encapsulation layer (310, 330);
a first separator (SP, SP1) in a first non-display area (NDA1) between the opening (100H) of the substrate (100) and the display area (DA); and
a second separator (SP) spaced apart from the first separator (SP, SP1) in the first non-display area (NDA1),
wherein the first separator (SP, SP1) comprises:
a first inorganic insulating layer (1110); and
a second inorganic insulating layer (1120) on an upper surface of the first inorganic insulating layer (1110) in a first direction (z) perpendicular to the substrate (100), and
wherein the first separator (SP, SP1) comprises a first cantilever portion (SPC) and a second cantilever portion (SPC) opposite to the first cantilever portion (SPC), wherein the first cantilever portion (SPC) has a first gap (g1, g1', g1‴) in the first direction (z) from a lower layer (203) under the first separator (SP, SP1), and has a first length (ℓ) in a second direction crossing the first direction (z).

2. The display panel (10) of claim 1, wherein the first separator (SP, SP1) further comprises an intermediate portion between the first cantilever portion (SPC) and the second cantilever portion (SPC), and
a first height (H1) from the lower surface of the substrate (100) to an upper surface of the intermediate portion is less than a second height (H2, H4) from the lower surface of the substrate (100) to an upper surface of at least one of the first cantilever portion (SPC) or the second cantilever portion (SPC).

3. The display panel (10) of claim 1 or 2, further comprising a first metal residue (MR1) between the first cantilever portion (SPC) and the lower layer (203).

4. The display panel (10) of any one of the preceding claims, wherein the first cantilever portion (SPC) has a structure including a portion of the first inorganic insulating layer (1110) and a portion of the second inorganic insulating layer (1120) overlapping each other.

5. The display panel (10) of claim 4, wherein the portion of the second inorganic insulating layer (1120) is in direct contact with the portion of the first inorganic insulating layer (1110).

6. The display panel (10) of claim 4, wherein the portion of the second inorganic insulating layer (1120) has a second gap (g2', g2") in the first direction (z) from the portion of the first inorganic insulating layer (1110).

7. The display panel (10) of claim 6, further comprising a second metal residue (MR2) under the portion of the second inorganic insulating layer (1120).

8. The display panel (10) of any one of the preceding claims, wherein the first cantilever portion (SPC) includes a portion of the second inorganic insulating layer (1120), wherein the portion of the second inorganic insulating layer (1120) has the first gap (g1‴) in the first direction (z) from the lower layer (203).

9. The display panel (10) of claim 8, wherein a width (Wb) of the first inorganic insulating layer (1110) is less than a width (Wt) of the second inorganic insulating layer (1120), and the second inorganic insulating layer (1120) is in direct contact with an entire upper surface of the first inorganic insulating layer (1110).

10. The display panel (10) of claim 8 or 9, wherein the second cantilever portion (SPC) includes a portion of the first inorganic insulating layer (1110),
wherein the second cantilever portion (SPC) has a second gap (g2‴) in the first direction (z) from the lower layer (203), and wherein the second gap (g2‴) is less than the first gap (g1‴).

11. The display panel (10) of any one of the preceding claims, wherein the lower layer (203) includes a recess (203r) located in a separation region between the first separator (SP, SP1) and the second separator (SP).

12. The display panel (10) of any one of the preceding claims, wherein the at least one inorganic encapsulation layer (310, 330) of the thin-film encapsulation layer (300) is in direct contact with each of a portion of the first cantilever portion (SPC) and a portion of the second cantilever portion (SPC) of the first separator (SP, SP1).

13. An electronic apparatus (1) comprising:
a display panel (10) of any one of the preceding claims, further including a transmissive area (TA), wherein the display area (DA) surrounds the transmissive area (TA), and the first non-display area (NDA1) is between the transmissive area (TA) and the display area (DA); and
a component (70) overlapping the transmissive area (TA) of the display panel (10),
wherein the opening (100OP) corresponds to the transmissive area (TA); and
wherein each of the first separator (SP, SP1) and the second separator (SP) comprises:
the first inorganic insulating layer (1110); and
the second inorganic insulating layer (1120),
wherein the first inorganic insulating layer (1110) of the first separator (SP, SP1) is separated from the first inorganic insulating layer (1110) of the second separator.

14. The electronic apparatus (1) of claim 13, wherein the display panel (10) includes an opening (10OP) passing through the display panel (10) and arranged in the transmissive area (TA) corresponding to the opening (100OP) of the substrate (100).

15. The electronic apparatus (1) of claim 13 or 14, wherein the component (70) includes a sensor or a camera.
